# EUROPÄISCHE PATENTSCHRIFT

(11) **EP 2 667 407 B1**
(45) Veröffentlichungstag und Bekanntmachung des Hinweises auf die Patenterteilung: **23.01.2019**
(21) Anmeldenummer: 13180205.0
(22) Anmeldetag: 01.09.2009
(51) Int. Cl.: H01L 21/67, H01L 21/683

(54) **Verfahren zum Ablösen eines Produktsubstrats (z.B. eines Halbleiterwafers) von einem Trägersubstrat mittels eines Lösungsmittels und Schallwellen durch Verformung eines auf einem Filmrahmen montierten flexiblen Films**
Method for releasing a product substrate (e.g., a semiconductor wafer) from a support substrate using a solvent and acoustic waves by deformation of a flexible film mounted on a frame
Procédé de séparation d'un substrat de produit (par exemple, d'une tranche semi-conductrice) d'un substrat de support au moyen d'un solvant et d'ondes acoustiques par déformation d'un film flexible monté sur un cadre

(43) Veröffentlichungstag der Anmeldung: 27.11.2013
(62) Teilanmeldung aus: 09011198.0
(73) Patentinhaber: EV Group GmbH, 4782 St. Florian am Inn (AT)
(72) Erfinder: Lindner, Friedrich Paul, 4780 Schärding (AT); Burggraf, Jürgen, 4780 Schärding (AT)
(74) Vertreter: Schweiger, Johannes

(56) Entgegenhaltungen:
- DE-A1- 4 407 735
- JP-A- 2002 203 821
- JP-A- 2007 305 628
- US-A1- 2007 295 458
- HOWELL W C: "The Direct Demount of Thinned GaAs Wafers to Sawing Tape", DIGEST OF PAPERS / 1990 U.S. CONFERENCE ON GAAS MANUFACTURING TECHNOLOGY : APRIL 1 - 3, 1990, BALLY'S RENO, RENO, NEVADA,, 1990, Seiten 48-51, XP009152870,

## Beschreibung

Die Erfindung betrifft ein Verfahren gemäß Anspruch 1 zum Ablösen eines Produktsubstrats von einem Trägersubstrat.

Das Rückdünnen von Produktsubstraten ist in der Halbleiterindustrie häufig erforderlich und kann mechanisch und/oder chemisch erfolgen. Zum Rückdünnen werden die Produktsubstrate in der Regel auf einen Träger vorübergehend fixiert, wobei es für die Fixierung verschiedene Methoden gibt. Als Trägermaterial werden beispielsweise Folien, Glassubstrate oder Siliziumwafer verwendet.

In Abhängigkeit von den verwendeten Trägermaterialien und der verwendeten Verbindungsschicht zwischen Träger und Produktsubstrat sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel.

Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus haben die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Als nächstliegender Stand der Technik wird die Druckschrift HOWELL W C: "The Direct Demount of Thinned GaAs Wafers to Sawing Tape", DIGEST OF PAPERS / 1990 U.S. CONFERENCE ON GAAS MANUFACTURING TECHNOLOGY: 1.-3. APRIL 1990, BALLY'S RENO, RENO, NEVADA, Seiten 48-51 genannt, die den Oberbegriff des Anspruchs 1 offenbart. Als weiterer Stand der Technik werden die Druckschriften JP2002-203821A, US2007/0295458A1, JP2007-305628A und DE4407735A1 genannt.

Es ist daher die Aufgabe der vorliegenden Erfindung, eine Vorrichtung und ein Verfahren anzugeben, um ein solches Produktsubstrat möglichst zerstörungsfrei von einem Träger zu lösen.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zugrunde, ein gattungsgemäßes Verfahren dadurch weiterzubilden, indem die Elastizität oder Flexibilität eines auf einem Filmrahmen montierten Films genutzt wird, um das Produktsubstrat schonend und vom Rand des Produktsubstrats her abzulösen und zwar durch Verformung des Films, insbesondere in einem Ablöseanschnitt des Films. Auf diese Weise steht das Produktsubstrat unmittelbar nach dem Abtrennen für weitere Prozessschritte zur Verfügung und ist durch den Film und den Filmrahmen geschützt. Viele Prozessschritte können direkt an dem filmrahmenmontierten Produktsubstrat durchgeführt werden.

Mit anderen Worten: Der flexible Film gibt mittels einer am Filmrahmen anliegenden Kraft und der das Produktsubstrat kontaktierenden Klebeschicht im Kontaktierungsflächenabschnitt des Films eine Zugkraft auf das Produktsubstrat ab, wodurch das Produktsubstrat von den Trägersubstrat abgelöst, insbesondere abgeschält wird.

Mit Produktsubstrat ist ein Produktsubstrat, beispielsweise ein Halbleiterwafer, gemeint, das üblicherweise auf eine Dicke zwischen 0,5 µm und 250 µm gedünnt ist, wobei die Tendenz zu immer dünneren Produktsubstraten geht. Besonders effektiv arbeitet die vorliegende Erfindung mit Produktsubstraten, die selbst eine ähnliche Flexibilität wie der am Filmrahmen montierte Film aufweisen. Das Produktsubstrat wird bei dem erfindungsgemäßen Verfahren von dem Trägersubstrat abgeschält, insbesondere konzentrisch vom Umfang des Produktsubstrats ausgehend.

Als Träger wird beispielsweise ein Trägersubstrat mit einer Dicke zwischen 50 µm und 5.000 µm, insbesondere zwischen 500 µm und 1000 µm verwendet.

Als Verbindungsschicht kommt ein Kleber, beispielsweise ein lösbarer Kleber, insbesondere ein Thermoplast in Frage, der beispielsweise selektiv in einem Randbereich des Trägersubstrat-Produktsubstrat-Verbundes, insbesondere in einer Randzone von 0,1 bis 20 mm, aufgebracht wird. Alternativ kann der Kleber vollflächig aufgebracht werden, wobei die Klebekraft im Zentrum durch eine haftreduzierende Schicht, beispielsweise ein Fluorpolymer, vorzugsweise Teflon, reduziert sein kann.

Als Aufnahmeeinrichtung eignet sich besonders ein Chuck, insbesondere ein Spinner Chuck zur Aufnahme des Trägersubstrats, insbesondere mittels Unterdruck, beispielsweise Saugbahnen, Bohrungen oder Saugnäpfen. Alternativ ist eine mechanische Aufnahme, beispielsweise durch seitliche Klammern, denkbar. In einer weiteren, alternativen Ausgestaltung erfolgt die Aufnahme elektrostatisch.

Die Ablösungsmittel umfassen den auf den Filmrahmen montierten Film und eine den Filmrahmen aufnehmende und kraftbeaufschlagende Filmrahmenaufnahme.

Zusätzlich zu den Ablösemitteln sind Verbindungslösemittel zur zumindest partiellen Lösung der durch die Verbindungsschicht bewirkten Verbindung zwischen dem Trägersubstrat und dem Produktsubstrat vorgesehen.

Soweit die Vorrichtung Heizmittel zur Aufheizung des Trägersubstrat-Produktsubstrat-Verbundes aufweist, die insbesondere in die Trägersubstrataufnahme integriert sind, kann ein thermoplastisch schmelzender Kleber als Verbindungsschicht verwendet werden. Die maximale Heiztemperatur beträgt 250°C, bevorzugt maximal 175°C.

In einer vorteilhaften Ausführungsform der Erfindung ist vorgesehen, dass das Verbindungslösemittel im Wesentlichen erhitzungsfrei arbeitend ausgebildet ist. Auf diese Weise ist es möglich, auf jegliche Heizeinrichtung zu verzichten.

Erfindungsgemäß ist vorgesehen, dass das Verbindungslösemittel Fluidmittel, nämlich ein die Verbindungsschicht selektiv auflösendes Lösungsmittel, zur Lösung der Verbindungsschicht umfasst. Die chemische Auflösung der Verbindungsschicht ist für das Produktsubstrat besonders schonend und bei entsprechender Materialwahl kann die Auflösung auch sehr schnell erfolgen, insbesondere wenn nur Randbereiche des Produktsubstrats mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

In einer Ausführungsform der Erfindung ist vorgesehen, dass das Verbindungslösemittel zusätzlich mechanische Trennmittel, insbesondere eine Klinge zum Durchschneiden der Verbindungsschicht, zur Lösung der Verbindungsschicht umfasst. Hierdurch ist eine besonders schnelle Trennung des Produktsubstrats vom Träger möglich.

In einer weiteren Ausführungsform der Erfindung ist vorgesehen, dass das Verbindungslösemittel zusätzlich eine UV-Lichtquelle zur Lösung der Verbindungsschicht umfasst. Soweit das Verbindungslösemittel, insbesondere ausschließlich, von einem Seitenrand des Produktsubstrats wirkend ausgebildet ist, kann auf eine Einwirkung auf das Produktsubstrat und/oder den Träger von der Oberseite und/oder der Unterseite, insbesondere einem innerhalb des Seitenrandes liegenden Innenbereich des Produktsubstrats, verzichtet werden.

Indem eine Rotationseinrichtung zur Rotation des Trägersubstrats, Produktsubstrats und/oder des Filmrahmens mit dem Film vorgesehen ist, kann auf eine Anordnung der Verbindungslösemittel über den gesamten Umfang des Produktsubstrats verzichtet werden und eine teilweise Beaufschlagung am Umfang des Produktsubstrats ist ausreichend.

Soweit der Ablöseabschnitt außerhalb der Außenkontur des Produktsubstrats liegt und/oder an den Kontaktierungsabschnitt anschließt, ist eine optimale Übertragung der Ablösekraft durch Verformung des Films auf das Produktsubstrat möglich.

Zur Beaufschlagung der Verbindungsschicht mit Fluidmittel ist zur Aufnahme des Fluidmittels ein am Trägersubstrat oder einer Trägersubstrataufnahme, insbesondere gedichtet, angeschlagener Lösungsmittelbehälter vorgesehen, dessen Oberkante sich zumindest bis zur durch das Produktsubstrat gebildeten Ebene erstreckt. Indem der Lösungsmittelbehälter den Seitenrand beziehungsweise Umfang des Produktsubstrats zumindest teilweise umgreift, ist eine besonders effektive Einwirkung auf die Verbindungsschicht möglich. Weiterhin kann durch die Maßnahme des Umgreifens verhindert werden, dass Fluidmittel aus dem Lösungsmittelbehälter austritt oder UV-LichtIntensität verloren geht. Beim Einsatz von mechanischen Trennmitteln wird vermieden, dass etwaige Verunreinigungen aus dem Lösungsmittelbehälter austreten und das Produktsubstrat verunreinigen. Der Lösungsmittelbehälter kann in vorteilhafter Ausgestaltung im Querschnitt L- oder U-förmig ausgebildet sein.

In einer weiteren vorteilhaften Ausgestaltung der Erfindung ist vorgesehen, dass sich der Lösungsmittelbehälter nur über einen Umfangssektor des Seitenrandes beziehungsweise Umfangs des Produktsubstrats erstreckt. Mit Vorteil erstreckt sich der Lösungsmittelbehälter nur geringfügig über den Seitenrand beziehungsweise Umfang des Trägersubstrats oder Produktsubstrats in Richtung des Produktsubstratzentrums hinein, damit am Trägersubstrat eine Kraft Fs angelegt werden kann. Die Kraft Fs kann auch über den Lösungsmittelbehälter auf das Trägersubstrat übertragen werden.

Erfindungsgemäß ist vorgesehen, dass die Ablösung durch eine auf das Trägersubstrat wirkende Kraft Fs und eine entgegen der Kraft Fs gerichtete, auf den Filmrahmen wirkende Kraft Ff resultiert. Die Vorrichtung kann die Kraft Ff als lokale Kraft, insbesondere punktuell an mindestens einer Stelle des Filmrahmens einleitend ausgebildet sein. Mit Vorteil wird die Kraft Ff auf mehrere Punkte am Umfang des Filmrahmens verteilt eingeleitet, wobei auch unterschiedliche Kräfte eingeleitet werden können und ein Kippen des Filmrahmens gegenüber dem Trägersubstrat bzw. der Trägersubstrataufnahme durch die Vorrichtung bewirkt werden kann. Indem der Film durch die Kraft Fs und die Kraft Ff im Ablöseabschnitt verformbar, insbesondere spannbar ist, wird eine homogene Kraftverteilung am Umfang des Produktsubstrats je nach der gewünschten Form der Ablösung erreicht.

Erfindungsgemäß ist vorgesehen, dass durch die Kraft Fs und die Kraft Ff eine Verschiebung des Filmrahmens gegenüber dem Trägersubstrat bewirkt wird, wobei hierdurch innerhalb des Filmrahmens eine Wanne entsteht, die zur Übertragung von Schallwellen auf das Lösungsmittel und gegebenenfalls auf das Produktsubstrat Schallwellenerzeugungsmittel, gebildet aus einem in der Wanne aufgenommenen Fluid und einem in das Fluid getauchten Schallgeber, aufweist. Die Ablösung des Produktsubstrats wird durch die vom Ultra- oder Megaschall erzeugte Kavitation deutlich beschleunigt, so dass das Ablösen wesentlich schonender und gleichzeitig schneller erfolgt.

Mit Vorteil ist weiterhin vorgesehen, dass die Ablösung des Produktsubstrats konzentrisch vom Umfang des Produktsubstrats zum Zentrum des Produktsubstrats erfolgt.

Besonders vorteilhaft ist es, wenn dass das Produktsubstrat während des Ablösevorgangs am Film haftend ausgebildet ist, da damit eine vollflächige Aufnahme und Schutz gewährleistet sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
Fig. 1a: Eine schematische Aufsicht auf einen aus Produktsubstrat, Trägersubstrat und Verbindungsschicht bestehenden Substratverbund auf einem Filmrahmen,
Fig. 1b: eine schematische Seitenansicht zu Figur la mit einer Detailansicht,
Figur 2: eine schematische Darstellung einer beispielhaften Vorrichtung, die nicht zum beanspruchten Gegenstand gehört, beim Ablösen des Produktsubstrats vom Trägersubstrat mit einer Detailansicht,
Figur 3 eine schematische Darstellung einer beispielhaften Vorrichtung, die nicht zum beanspruchten Gegenstand gehört, beim Ablösen des Produktsubstrats vom Trägersubstrat mit einer Detailansicht und
Figur 4: eine schematische Darstellung einer Ausführungsform der Erfindung.

In den Figuren sind gleiche Bauteile und Bauteile mit der gleichen Funktion mit den gleichen Bezugszeichen gekennzeichnet.

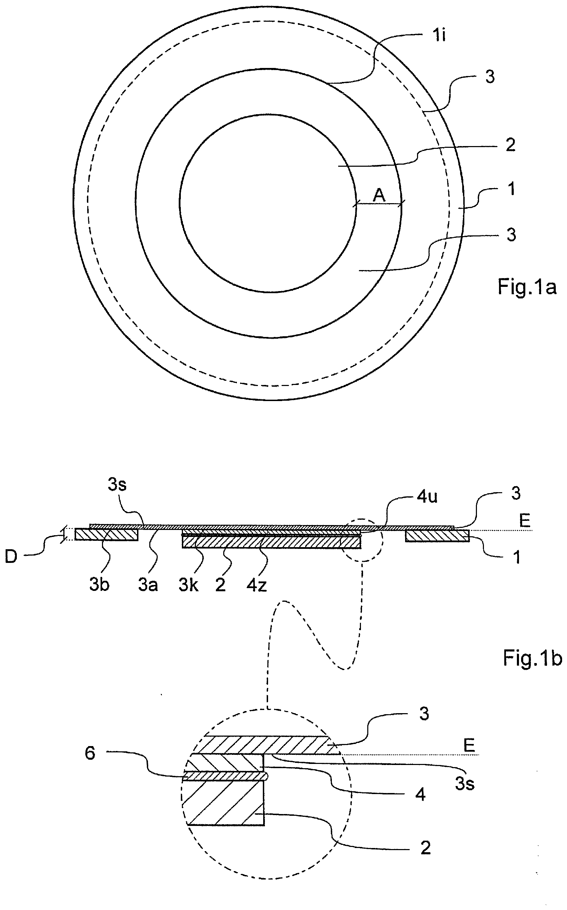

In Figur 1a ist ein in dieser Ausführungform zumindest an einem Innenumfang 1i kreisrunder Filmrahmen 1 mit einem an dessen Unterseite montierten, insbesondere geklebten, Film 3 dargestellt. Mit Radialabstand zu dem Innenumfang 1i des Filmrahmens 1 ist innerhalb des Filmrahmens 1 ein Produktsubstrat-Trägersubstrat-Verbund auf einer Klebeschicht 3s des Films 3 konzentrisch zu dem Filmrahmen 1 aufgeklebt (siehe Figur 1b).

Der Produktsubstrat-Trägersubstrat-Verbund besteht aus einem am Film 3 haftenden Produktsubstrat 4, einem Trägersubstrat 2 und einer das Produktsubstrat 4 und das Trägersubstrat 2 verbindenden Verbindungsschicht 6. Die Durchmesser des Produktsubstrates 4 und des Trägersubstrates 2 sind im Wesentlichen identisch, während die Dicke des Produktsubstrates 4 geringer ist als die Dicke des Trägersubstrates 2.

Der Film 3 besteht aus einem im vorliegenden Fall kreisringförmigen Befestigungsabschnitt 3b, in welchem der Film 3 mit dem Filmrahmen 1 fixiert ist. Weiterhin besteht der Film 3 aus einem Kontaktierungsflächenabschnitt 3k, in welchem das Produktsubstrat 4 an der Klebeschicht 3s des Films 3 fixierbar ist. Zwischen dem Befestigungsabschnitt 3b und dem Kontaktierungsflächenabschnitt 3k liegt ein, insbesondere konzentrisch zu dem Befestigungsabschnitt 3b und dem Kontaktierungsflächenabschnitt 3k angeordneter Ablöseabschnitt 3a, dem eine erfindungsgemäß entscheidende Funktion zukommt. Der Ablöseabschnitt 3a erstreckt sich damit von einem Umfang 4u des Produktsubstrates 4 bis zu dem Innenumfang 1i des Filmrahmens, vorliegend als Abstand A bezeichnet. Das Verhältnis zwischen einer Dicke D des Filmrahmens 1 und des Abstands A beträgt mit Vorteil mindestens 1 zu 2 bis 1 zu 50, insbesondere 1 zu 5 bis 1 zu 25, bevorzugt 1 zu 19 oder 1 zu 10.

In der in Figur 1b gezeigten Ausgangslage sind die den Film 3 kontaktierende Seite des Produktsubstrates 4 und die den Film 3 kontaktierende Seite des Filmrahmens 1 fluchtend und in einer Ebene E angeordnet. Die in den Figuren 1a und 1b gezeigten Teile werden auf einem bekannten Filmframemounter zusammengebaut.

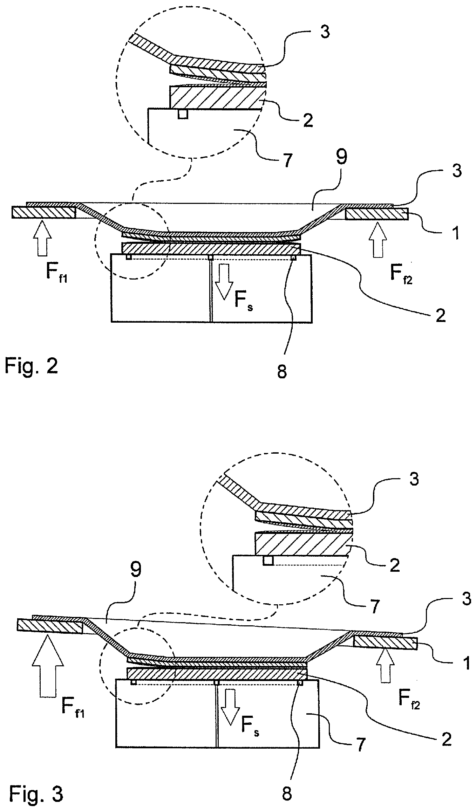

In den Figuren 2 und 3 ist der Ablösevorgang in zwei Varianten schematisch dargestellt, und zwar kurz nach Beginn des Ablösens des Produktsubstrates 2 vom Trägersubstrat 4.

Durch Einleiten entgegenwirkender Kräfte Ff, bzw. Ffl und Ff2, und Fs wird der Produktsubstrat-Trägersubstrat-Verbund und der daran klebende Kontaktierungsflächenabschnitt 3k des Films 3 aus dem Filmrahmen 1 in Richtung einer Trägersubstrataufnahme 7 bewegt. In kinematischer Umkehr kann auch der Filmrahmen 1 durch die Kraft Ff mittels einer nicht dargestellten Filmrahmenaufnahme, beispielsweise eines Roboterarmes, bewegt werden.

Die Kraftübertragung von der Trägersubstrataufnahme 7 auf das Trägersubstrat 2 erfolgt über in die Oberfläche der Trägersubstrataufnahme 7 eingearbeitete Vakuumbahnen 8 und eine daran angeschlossene, nicht dargestellte Vakuumeinrichtung. Die Trägersubstrataufnahme 7 ist fest mit der Vorrichtung verankert. Alternativ kann die Aufnahme des Trägersubstrates 2 mechanisch, beispielsweise durch Klemmung, oder elektrostatisch erfolgen. Die auf den Filmrahmen 1 wirkende Kraft Ff kann - wie in Figur 2 dargestellt - gleichmäßig verteilt als Flächenkraft auf den Filmrahmen 1 wirken, so dass über die Verformung des Ablöseabschnitts 3a die Ablösung des Produktsubstrates 4 von dem Trägersubstrat 2 vom Rand her erfolgt, wie in der Detaildarstellung in Figur 2 vergrößert dargestellt. Die Kraft Ffl ist dabei mit der Kraft Ff2 identisch. Die Kraft kann punktuell verteilt am Umfang des Filmrahmens 1 eingeleitet werden oder durch eine Filmrahmenaufnahme verteilt eingebracht werden.

Im in Figur 3 dargestellten nicht zum beanspruchten Gegenstand gehörenden Beispiel ist die Kraftverteilung am Umfang des Filmrahmens 1 unterschiedlich, und zwar ist die Kraft Ffl größer als die Kraft Ff2 auf der gegenüberliegenden Seite, so dass das Produktsubstrat 4 zunächst auf der Seite, an der die größere Kraft Ffl eingeleitet wird, abgelöst wird. Die Aufnahmeeinrichtung zur Einleitung der Kraft in den Filmrahmen 1 muss daher ein Kippen des Filmrahmens 1 zulassend ausgebildet sein.

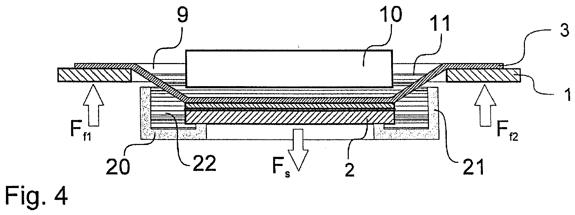

Das Produktsubstrat 4 fördert das Ablösen, da es sich ähnlich elastisch wie der Film 3 verhält und sich damit vom Produktsubstrat-Trägersubstrat-Verbund Schritt für Schritt von dessen Rand her löst. Gemäß Figur 4 ist ein Lösungsmittelbehälter 20 derart an dem Trägersubstrat 2 angeordnet, dass ein Eintauchen des Produksubstrat-Trägersubstrat-Verbundes in der mit Kraft beaufschlagten Stellung des Produktsubstrat-Trägersubstrat-Verbundes ermöglicht wird. Der Lösungsmittelbehälter 20 ist, in vorliegenden Fall ringförmig, am Umfang des Trägersubstrates 2, insbesondere dichtend angebracht, so dass eine Krafteinleitung innerhalb des Lösungsmittelbehälters 20 auf das Trägersubstrat 2 nach wie vor möglich ist. Die Krafteinleitung kann alternativ auch am Lösungsmittelbehälter 20 erfolgen, beispielsweise wenn der Lösungsmittelbehälter 20 kraftschlüssig am Trägersubstrat 2 angebracht ist. Eine äußere Umfangswand 21 des Lösungsmittelbehälters 20 erstreckt sich mindestens bis zu einer durch das Produktsubstrat 4 gebildeten Ebene, damit das Lösungsmittel 22 im Lösungsmittelbehälter 20 mindestens bis zur Verbindungsschicht 6 reicht und diese durch das Lösungsmittel 22 aufgelöst werden kann. Mit Vorteil erstreckt sich die äußere Umfangswand 21 über die durch das Produktsubstrat 4 gebildete Ebene hinaus bis fast zum Filmrahmen 1, damit auch bei einer Rotation ein Austreten des Lösungsmittels 22 aus dem Lösungsmittelbehälter 20 möglichst vermieden wird.

Durch diese Maßnahme wird das Ablösen, insbesondere Abschälen des Produktsubstrates 4 von dem Trägersubstrat 2 unterstützt, indem vom Umfang 4u des Produktsubstrates 4 die Verbindungsschicht 6 aufgelöst wird und durch die Verformung des Films 3 am Umfang 4u anliegende Zugkraft wird das Produktsubstrat 4 schonend abgehoben.

Durch die Verformung des Films 3 entsteht eine Wanne 9. Das Einleiten eines Fluids 11 in die Wanne 9 erfolgt zur Übertragung von Schallwellen (Ultraschall, Megaschall) über den Film 3 in das gegenüberliegend des Films 3 angeordnete Lösungsmittel 22 sowie in den Produktsubstrat-Trägersubstrat-Verbund mittels eines Schallwellenerzeugungsmittels, vorliegend Schallgebers 10. Das Lösungsmittel 22 wirkt durch die Schalleinbringung vom Rand her beschleunigt auf die Verbindungsschicht 6, so dass die Rückstellkraft des Films 3 in Richtung Filmrahmen 1 verringert werden kann und/oder das Ablösen unterstützt wird, insbesondere bei radialsymmetrischen Ablösen gemäß Figur 2.

Durch das Einleiten von Schall werden Lösungsmittelmoleküle des Lösungsmittels 22 in Schwingung versetzt, wodurch es zu Kavitation kommt, was zu einer deutlichen Beschleunigung der Auflösung der Verbindungsschicht 6 führt.

Das Lösungsmittel 22 ist selektiv auf die Verbindungsschicht 6 abgestimmt und die Klebeschicht 3s ist von dem Lösungsmittel 22 nicht angreifbar.

### Bezugszeichenliste

- A: Abstand
- D: Dicke
- E: Ebene
- 1: Filmrahmen
- 1i: Innenumfang
- 2: Trägersubstrat
- 3: Film
- 3a: Ablöseabschnitt
- 3b: Befestigungsabschnitt
- 3k: Kontaktierung sflächenabschnitt
- 3s: Klebeschicht
- 4: Produktsubstrat
- 4u: Umfang
- 6: Verbindungsschicht
- 7: Trägersubstrataufnahme
- 8: Vakuumbahnen
- 9: Wanne
- 10: Schallgeber
- 11: Fluid
- 20: Lösungsmittelbehälter
- 21: äußere Umfangswand
- 22: Lösungsmittel

## Patentansprüche

1. Verfahren zum Ablösen eines Produktsubstrats (4) vom Rand des Produktsubstrats (4) her von einem mit dem Produktsubstrat (4) durch eine Verbindungsschicht (6) verbundenen Trägersubstrat (2) mittels eines auf einem Filmrahmen (1) montierten flexiblen Films (3), der eine Klebeschicht (3s) zur Aufnahme des Produktsubstrats (4) in einem Kontaktierungsflächenabschnitt (3k) des Films (3) umfasst, wobei das Produktsubstrat (4), die Verbindungsschicht (6) und das Trägersubstrat (2) einen Produktsubstrat-Trägersubstrat-Verbund bilden, wobei der Film (3) in einem den Kontaktierungsflächenabschnitt (3k) umgebenden kreisringförmigen Befestigungsabschnitt (3b) des Films (3) auf dem Filmrahmen (1) montiert ist, und wobei der Film (3) einen zwischen dem Kontaktierungsflächenabschnitt (3k) und dem Befestigungsabschnitt (3b) liegenden Ablöseabschnitt (3a) umfasst, der sich von einem Umfang (4u) des Produktsubstrats (4) bis zu dem Innenumfang (1i) des Filmrahmens (1) erstreckt,
- wobei Ablösemittel eine Ablösung des Produktsubstrats (4) vom Trägersubstrat (2) vom Umfang (4u) des Produktsubstrats (4) her bewirken, wobei die Ablösemittel den auf dem Filmrahmen (1) montierten Film (3) und eine den Filmrahmen (1) aufnehmende und kraftbeaufschlagende Filmrahmenaufnahme umfassen, wobei das Produktsubstrat (4) durch Verformung des flexiblen Films (3) in dem Ablöseabschnitt (3a) mittels einer auf das Trägersubstrat (2) wirkenden Kraft Fs und einer entgegen der Kraft Fs gerichteten, auf den Filmrahmen (1) wirkenden Kraft Ff abgelöst wird,
- wobei zusätzlich zu den Ablösemitteln Verbindungslösemittel zur zumindest partiellen Lösung der durch die Verbindungsschicht (6) bewirkten Verbindung zwischen dem Trägersubstrat (2) und dem Produktsubstrat (4) vorgesehen sind,
- wobei die Verbindungslösemittel Fluidmittel, nämlich ein die Verbindungsschicht selektiv auflösendes Lösungsmittel (22), umfassen,
**dadurch gekennzeichnet, dass**
das Lösungsmittel (22) im Bereich des Umfangs des Produktsubstrats (4) zur zumindest partiellen Lösung der Verbindungsschicht (6) wirkt und ein das Lösungsmittel (22) enthaltender Lösungsmittelbehälter (20) derart an dem Trägersubstrat (2) angeordnet ist, dass der Produktsubstrat-Trägersubstrat-Verbund in einer mit der Kraft Fs und Ff beaufschlagten Stellung des Trägersubstrats (2) in das Lösungsmittel (22) eingetaucht wird,
und dadurch, dass durch die Kraft Fs und die Kraft Ff eine Verschiebung des Filmrahmens (1) gegenüber dem Trägersubstrat (2) bewirkt wird, wobei hierdurch innerhalb des Filmrahmens (1) eine Wanne (9) entsteht, die der Film (3) durch seine Verformung bildet und die zur Übertragung von Schallwellen auf das Lösungsmittel (22) Schallwellenerzeugungsmittel, gebildet aus einem in der Wanne (9) aufgenommenen, sich vollständig innerhalb der Wanne (9) befindenden Fluid (11) und einem in das Fluid (11) getauchten Schallgeber(10), aufweist, wobei die durch die Schallwellenerzeugungsmittel erzeugten Schallwellen über den Film (3) in das auf der dem Fluid (11) gegenüberliegenden Seite des Films (3) angeordnete Lösungsmittel (22) übertragen werden und die Ablösung des Produktsubstrats (4) durch vom Ultra- oder Megaschall erzeugte Kavitation deutlich beschleunigt wird.

2. Verfahren nach Anspruch 1,
**dadurch gekennzeichnet,**
**dass** eine Rotationseinrichtung zur Rotation des Trägersubstrats (2) und des Produktsubstrats (4) vorgesehen ist, wobei der Umfang des Produktsubstrats (4) mit dem Lösungsmittel (22) nur teilweise beaufschlagt wird.

3. Verfahren nach einem der Ansprüche 1 oder 2,
**dadurch gekennzeichnet,**
**dass** die Verbindungsschicht (6) als Kleber nur in einem Randbereich des Trägersubstrat-Produktsubstrat-Verbundes aufgebracht wird.

## Claims

1. Method for stripping a product substrate (4) from a carrier substrate (2) connected to the product substrate (4) by an interconnect layer (6) by means of a flexible film (3) that is mounted on a film frame (1) and that comprises an adhesive layer (3s) for holding the product substrate (4) in a bonding surface section (3k) of the film (3), wherein the product substrate (4), the interconnect layer (6) and the carrier substrate (2) form a product substrate-carrier substrate-compound, wherein the film (3) is mounted on the film frame (1) in an annular attachment section (3b) of the film (3) that surrounds the bonding surface section (3k), and wherein the film (3) comprises a stripping section (3a) that is located between the bonding surface section (3k) and the attachment section (3b) and the stripping section (3a) extending from a periphery (4u) of the product substrate (4) to an inner periphery (1i) of the film frame (1),
- wherein stripping means cause stripping of the product substrate (4) from the carrier substrate (2) from a periphery (4u) of the product substrate (4), wherein the stripping means comprise the film (3) mounted to the film frame (1) and a film frame holder for holding the film frame (1) and acting with a force on the film frame (1), wherein the product substrate is stripped by deforming the flexible film (3) in the stripping section (3a) by means of a force Fs and the force Ff, which is directed against the force Fs,
- wherein additionally to the stripping means connection release means are provided for at least partial release of the bond caused by the connection layer (6) between the carrier substrate (2) and the product substrate (4),
- wherein the connection release means comprise fluid means, namely a solvent (22), which selectively dissolves the connection layer,
**characterized in that**
the solvent (22) acts in an area of the periphery of the product substrate (4) for at least partial release of the connection layer (6), and wherein a solvent reservoir (20) containing the solvent (22) is arranged at the carrier substrate (2) such that the product substrate-carrier substrate-compound is immersed into the fluid in a position in which the forces Fs and Ff are acting on the carrier substrate (2)
and **in that** the force Fs and the force Ff cause displacement of the film frame (1) relative to the carrier substrate (2), in this way within the film frame (1) a trough (9) being formed that has acoustic wave generating means, formed from a fluid (11) that is held in the trough (9) and an acoustic transmitter (10) immersed into the fluid (11), wherein the acoustic waves generated by the acoustic wave generating means are transmitted via the film (3) to the solvent (22), which is arranged on the opposite side of the film (3), and wherein the stripping of the product substrate (4) is greatly accelerated by the cavitation generated by ultrasound or megasound.

2. Method according to Claim 1, wherein rotation means for rotation of the carrier substrate (2) and the product substrate (4) are provided, wherein the solvent (22) is only partly applied to the periphery of the product substrate (4).

3. Method according to Claim 1 or 2, wherein the interconnect layer (6) is applied as an adhesive in a periphery of the product substrate-carrier substrate-compound.

## Revendications

1. Procédé de séparation d'un substrat de produit (4) depuis le bord du substrat de produit (4) d'un substrat porteur (2) relié au substrat de produit (4) par une couche de liaison (6), au moyen d'un film (3) flexible monté sur un cadre de film (1) qui comprend une couche de colle (3s) pour recevoir le substrat de produit (4) dans un tronçon de surface de contact (3k) du film (3), dans lequel le substrat de produit (4), la couche de liaison (6) et le substrat porteur (2) forment un composite de substrat de produit-substrat porteur, dans lequel le film (3) est monté sur le cadre de film (1) dans un tronçon de fixation (3b) du film (3) circulaire entourant le tronçon de surface de contact (3k), et dans lequel le film (3) comprend un tronçon de séparation (3a) reposant entre le tronçon de surface de contact (3k) et le tronçon de fixation (3b) qui s'étend d'un pourtour (4u) du substrat de produit (4) jusqu'au pourtour intérieur (1i) du cadre de film (1),
- dans lequel des moyens de séparation effectuent une séparation du substrat de produit (4) du substrat porteur (2) depuis le pourtour (4u) du substrat de produit (4), dans lequel les moyens de séparation comprennent le film (3) monté sur le cadre de film (1) et une réception de cadre de film fournissant une force et recevant le cadre de film (1), dans lequel le substrat de produit (4) est enlevé par déformation du film flexible (3) dans le tronçon de séparation (3a) au moyen d'une force Fs agissant sur le substrat porteur (2) et d'une force Ff dirigée contre la force Fs, agissant sur le cadre de film (1),
- dans lequel, en plus des moyens de séparation, des solvants de liaison pour la séparation au moins partielle de la liaison effectuée par la couche de liaison (6) sont prévus entre le substrat porteur (2) et le substrat de produit (4),
- dans lequel les solvants de liaison comprennent des agents fluidiques, à savoir un solvant dissolvant la couche de liaison de manière sélective,
**caractérisé en ce que**
le solvant (22) agit au niveau du pourtour du substrat de produit (4) pour la séparation au moins partielle de la couche de liaison (6) et un récipient de solvant (20) contenant le solvant (22) est ainsi disposé contre le substrat porteur (2) que le composite de substrat de produit-substrat porteur est plongé dans le solvant (22) dans une position du substrat porteur (2) recevant les forces Fs et Ff,
et **en ce que**, par la force Fs et la force Ff, un déplacement du cadre de film (1) par rapport au substrat porteur (2) a lieu, dans lequel un bac (9) est ainsi produit à l'intérieur du cadre de film (1), lequel forme le film (3) par sa déformation et présente les moyens de production d'ondes sonores pour transmettre des ondes sonores au solvant (22), formés d'un
fluide (11) reçu dans le bac (9), se trouvant intégralement à l'intérieur du bac (9) et d'une source sonore (10) plongée dans le fluide (11), dans lequel les ondes sonores produites par les moyens de production d'ondes sonores sont transmises par le biais du film (3) dans le solvant (22) disposé sur le côté du film (3) face au fluide (11) et la séparation du substrat de produit (4) est considérablement accélérée par de la cavitation produite par ultrason ou méga-son.

2. Procédé selon la revendication 1, **caractérisé en ce qu'**un dispositif de rotation pour la rotation du substrat porteur (2) et du substrat de produit (4) est prévu, dans lequel le pourtour du substrat de produit (4) ne reçoit que partiellement le solvant (22).

3. Procédé selon la revendication 1 ou 2, **caractérisé en ce que** la couche de liaison (6) est appliquée en tant que colle uniquement dans une zone de bordure du composite de substrat de produit-substrat porteur.
